Europäisches Patentamt

European Patent Office

Office européen des brevets

(19)

(11) Publication number: **0 231 660 B1**

(12) **EUROPEAN PATENT SPECIFICATION**

(45) Date of publication of patent specification: **26.08.92**

(51) Int. Cl.5: **H01L 31/18**, H01L 31/08, H01L 29/78, H01L 21/205, C23C 16/48

(21) Application number: **86310162.2**

(22) Date of filing: **24.12.86**

(54) **Method for producing an electronic device having a multi-layer structure.**

(30) Priority: **28.12.85 JP 297833/85**

(43) Date of publication of application:
**12.08.87 Bulletin 87/33**

(45) Publication of the grant of the patent:
**26.08.92 Bulletin 92/35**

(84) Designated Contracting States:
**DE FR GB IT NL**

(56) References cited:
**EP-A- 0 228 295**
**DE-A- 3 429 899**
**GB-A- 2 083 705**

**JAPANESE JOURNAL OF APPLIED PHYSICS, vol. 24, no. 8, August 1985, part 1, pages 997-1002, Tokyo, JP; J. KENNE et al.: "Amorphous-silicon solar cells prepared by a combined photochemical-plasma CVD technique"**

(73) Proprietor: **CANON KABUSHIKI KAISHA**
**30-2, 3-chome, Shimomaruko, Ohta-ku**
**Tokyo(JP)**

(72) Inventor: **Ohtoshi, Hirokazu**
**636-710, Marukodori 1-chome Nakahara-ku**
**Kawasaki-shi Kanagawa-ken(JP)**
Inventor: **Hirooka, Masaaki**
**2139-19, Ino**
**Toride-shi Ibaraki-ken(JP)**
Inventor: **Hanna, Jun-ichi**
**5780, Nagatsuta-cho, Midori-ku**
**Yokohama-shi Kanagawa-ken(JP)**
Inventor: **Shimizu, Isamu**
**20-3-501, Edaminami 5-chome Midori-ku**
**Yokohama-shi Kanagawa-ken(JP)**

(74) Representative: **Beresford, Keith Denis Lewis et al**
**BERESFORD & Co. 2-5 Warwick Court High Holborn**
**London WC1R 5DJ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

APPLIED PHYSICS LETTERS, vol. 43, no. 8, 15th October 1984, pages 774-776, American Institute of Physics, New York, US; T. INOUE et al.: "Photochemical vapor deposition of undoped and n-type amorphous silicon films produced from disilane"

APPLIED PHYSICS LETTERS, vol. 45, no. 8, 15th October 1984, pages 865-867, American Institute of Physics, New York, US; T. TANAKA et al.: "Amorphous silicon solar cells fabricated by photochemical vapor deposition"

JAPANESE JOURNAL OF APPLIED PHYSICS, vol. 22, no. 1, January 1983, pages L46-L48, part 2, Tokyo, JP; Y. MISHIMA et al.: "Silicon thin-film formation by direct photochemical decomposition of disilane"

JOURNAL OF APPLIED PHYSICS, vol. 58, no. 9, 1st November 1985, pages 3664-3666, American Institute of Physics, Woodbury, New York, US; H. TAKEI et al.: "High-energy conversion efficiency amorphous silicon solar cells by photochemical vapor deposition"

JAPANESE JOURNAL OF APPLIED PHYSICS. SUPPLEMENTS, PROCEEDINGS OF THE 14TH CONFERENCE ON SOLID STATE DEVICES, Tokyo, 1982, vol. 22, no. 22-1, 1983, pages 617-618, Tokyo, JP; T. SAITOH et al.: "Novel amorphous silicon solar cells prepared by photochemical vapor deposition"

**Description**

BACKGROUND OF THE INVENTION

Field of the Invention

This invention relates to a multi-layer Structure which can be used to form an electronic device such as thin film semi-conductor device photovoltaic device, image forming member for electrophotography etc, and a method for producing the same.

Related Background Art

In the prior art, functional films,i.e. semiconductor thin films for electronic devices such as thin film semiconductor devices, imaging devices, etc, particularly amorphous or polycrystalline semiconductor films, are formed individually by film forming methods chosen according to desired physical characteristics, uses, etc of the film.

Various methods have been attempted for formation of a silicon-deposited film (amorphous or polycrystalline, i.e. non-single crystalline), or for silicon film which is optionally compensated for lone pair electrons with a compensating agent such as hydrogen atoms (H) or halogen atoms (X), etc, generally "NON-Si (H,X)", or "A-Si (H,X)" for amorphous or microcrystalline silicon and "poly-Si (H,X)" for polycrystalline silicon. These methods include vacuum vapor deposition, plasma CVD (PCVD), thermal CVD, reactive sputtering, ion plating, photo CVD, etc. Typical photo CVD deposition is described in Applied Physics Letters, Vol. 45, No. 8, pages 865 - 867 (1984) and Japanese Journal of Applied Physics, Vol. 22, No 1, Part 2, pages L46 - L48, (1983). Generally plasma CVD has been widely used industrially. One plasma CVD method is described in DE-A-3 429 899.

However, the prior art reaction process for plasma CVD formation of a silicon-deposited film is more complicated than the CVD method of the prior art, and its reaction mechanism is not clear. Also, there are a large number of parameters for formation of a deposited film (for example, substrate temperature, flow rates and flow rate ratio of introduced gases, pressure during formation, high frequency power, electrode structure, structure of reaction vessel, evacuation rate, plasma generating system, etc). Because of the dependency on such a large number of parameters, formed plasma may sometimes become unstable, which often leads to marked deleterious effects on the deposited film formed. Besides, such parameters characteristics of each apparatus must be selected individually. Therefore, under the present situation, it is difficult to standardise the production conditions.

On the other hand, for a silicon deposited film to exhibit sufficiently satisfactory electrical or optical characteristics for respective uses, it is now accepted that the best way to form it is by plasma CVD.

However, depending on the intended use of a silicon-deposited film, reproducable production in bulk may be required, whilst ensuring enlargement of area, uniformity of film thickness as well as uniformity of film quality. Therefore, for formation of silicon-deposited film by plasma CVD, enormous investment is required in bulk production apparatus. Also controls for such bulk production are complicated, since control tolerances are narrow. These problems are pointed out as requiring solution in the future.

Also, since plasma for plasma CVD is directly generated (by high frequency, microwave etc) in a space where film formation is to occur, electrons or a number of ion species damage the film being formed causing lowering of film quality of non-uniform film quality.

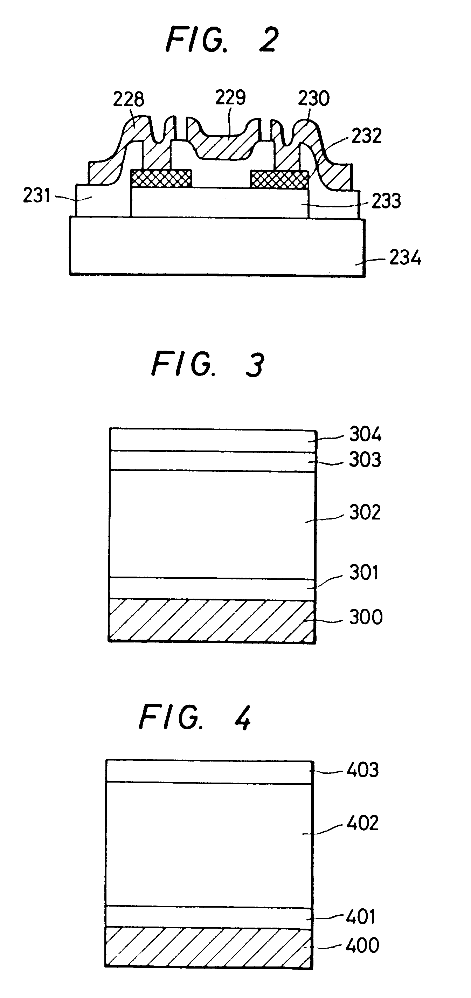

Particularly, in the case of producing an electronic device having a multi-layer structure, interface defects formed between the respective layers may cause worsening of the characteristics of the electronic device obtained. There is shown in Fig. 4 an image forming member for electrophotography as an example. There is found a layer constitution on a substrate 400 made of aluminum, consisting of a charge injection preventing layer (first layer, amorphous silicon layer doped with boron B) 401, a photosensitive layer (second layer, amorphous layer not doped with impurities such as B) 402 and a surface protective layer (third layer, amorphous silicon carbide layer) 403 respectively deposited. If all the layers are to be formed by the PCVD method, since the kinds of starting material gases, flow rates and plasma discharging intensity for formation of the respective deposited layers differ extremely from one another, efforts will be required to decrease the influence of the interfaces formed between the respective deposited layers ordinarily by stopping discharging between the steps for formation of the first layer and the second layer or for formation of the second layer and the third layer to exchange completely gases, or if continuous production is to be employed, by providing a varied layer by varying gradually the kinds of gases, flow rates and plasma discharging intensity, or by providing deposition chambers for formation of the respective deposited layers separately. In any case, ions generated in the plasma are collided against a layer formed to increase defects. Particularly, in producing an electronic device having a multi-layer constitution, influence of ion collision in plasma is noticeably severe on the interfaces of respective layers. For this reason, satisfactory improvement therein is required.

As described above, in formation of silicon series deposited film, points to be solved still remain, and it has been earnestly desired to develop a method for forming a deposited film which is capable of bulk production with conservation of energy by the use of an apparatus of low cost, while maintaining the characteristics as well as uniformity of the film at a practically applicable level. Particularly, it has been earnestly desired to improve the interface characteristics of an electronic device having a multi-layer structure such as thin film transistor, photovoltaic device, photosensitive member for electrophotography, etc.

## SUMMARY OF THE INVENTION

An object of the present invention is to remove such drawbacks of a method for forming a deposited film as described above and at the same time to provide a novel method for producing a multi-layer structure without the use of the formation method of the prior art.

Another object of the present invention is to provide a method for forming a deposited film with improved interface characteristics over a large area with easy control of film quality and conservation of energy.

Still another object of the present invention is to provide a method for producing a multi-layer structure which is excellent in productivity and bulk productivity, having high quality as well as excellent physical characteristics such as electrical, optical and semiconductor characteristics.

According to the present invention there is provided a method for producing a multi-layer structure comprising two or more semiconductor layers at least one of which is a thin layer controlled in valence electron, formed on a substrate, which comprises:

(a) forming at least one of said semiconductor thin layers controlled in valence electron according to optical CVD by bringing together a gaseous starting material and a valence electron controller;

(b) forming at least one of the other constituent layers, optionally controlled in valence electron, according to a method comprising:

(i) introducing a gaseous starting material for formation of a deposited film and a gaseous halogenic oxidising agent having the property of oxidising said starting material into a reaction space to effect chemical contact therebetween to thereby form a plural number of precursors containing a precursor under excited state; and

(ii) transferring at least one precursor of those precursors into a film forming space communicated with the reaction space as a feeding source for the constituent element of the deposited film.

According to the method of the present invention, a multi-layer structure improved in interface characteristics is obtained, and simplification of control and bulk production can be effected whilst ensuring enlargement of area, uniformity of film thickness and uniformity of film quality simultaneously with conservation of energy. This can be done without requiring enormous installation investment for bulk production apparatus. Also controls for bulk production are simplified allowing broad tolerances.

## BRIEF DESCRIPTION OF THE DRAWINGS

Fig 1 is a schematic illustration of an apparatus for forming a deposition film for practicing the method of the present invention.

Fig 2 is a schematic illustration of layers of a thin film transistor produced by the method of the present invention.

Fig 3 is a schematic illustration of layers of a solar cell produced by the method of the present invention.

Fig 4 is a schematic illustration of layers of an image forming member for electrophotography produced by the method of the present invention.

Fig 5 is a schematic illustration of an apparatus for forming a deposition film by optical CVD.

## DESCRIPTION OF THE PREFERRED EMBODIMENT

In the method for producing multi-layer structure of the present invention, gaseous starting material to be used for formation of a deposited film (semiconductor thin film by the FOCVD method) is to be oxidised

4

by chemical contact with a gaseous halogenic oxidising agent. The oxidising agent can be selected according to the kind of film desired, and according to its intended use. In the present invention, the above gaseous starting material and the gaseous halogenic oxidising agent need be made gaseous only during chemical contact when introduced into a reaction space. They can therefore be either liquid or solid in their ordinary state. When the starting material for formation of a deposited film or the halogenic oxidising agent is liquid or solid, it is introduced in gaseous state into the reaction space through perofrming bubbling with the use of a carrier gas such as Ar, He, $N_2$, $H_2$, etc, optionally with application of heat.

During this operation, the partial pressures and mixing ratio of the above gaseous starting material and the gaseous halogenic oxidising agent may be set by controlling the flow rate of the carrier gas and the vapor pressures of the starting material for formation of a deposited film and the gaseous halogenic oxidising agent.

The starting material for formation of a deposited film to be used in the FOCVD method of the present invention may be as follows. If a deposited film of a group IVA element, such as semiconductive or electrically insulating silicon deposited film or germanium deposited film, etc, is desired to be obtained, straight or branched chain silane compounds, cyclic silane compounds, chain germanium compounds, etc, may be employed as the starting material. specifically, examples of straight chain silane compounds may include $Si_nH_{2n+2}$ ( n = 1, 2, 3, 4, 5, 6, 7, 8), examples of branched silane compounds include $SiH_3SiH$-$(SiH_3)$-$SiH_2SiH_3$, examples of cyclic silane compounds include $Si_nH_{2n}$ (n = 3, 4, 5, 6). Examples of chain germanium compounds include $Ge_mH_{2m+2}$ ( m = 1, 2, 3, 4, 5), etc. If, however, a deposited film of tin is desired to be prepared, hydrogenated tin such as $SnH_4$, etc, may, for example, be employed as an effective starting material.

One or more of these starting materials may be used; and they may also be used as the starting material gas for the photo CVD method.

The halogenic oxidising agent to be used in the present invention is to be made gaseous when introduced into the reaction space. It then has the property of effectively oxidising the gaseous starting material by mere chemical contact therewith. The halogenic oxidising agent may be halogen gases such as $F_2$, $Cl_2$, $Br_2$, $I_2$, etc, and fluorine, chlorine, bromine etc, in their nascent states.

The halogenic oxidising agent is introduced into the reaction space under gaseous state together with the gas of the starting material for formation of a deposited film. This is done with desired flow rate and feeding pressure. The oxidising agent mixes with and collides against the starting material which it contacts. This oxidises the starting material, and generates efficiently a plurality of precursors which contain a precursor in chemically excited state. At least one of the precursors functions as a feeding source for the constituent element of the film to be deposited.

The precursors generated may undergo decomposition or reaction to be converted to other excited precursors, or to the same precursors but to other excited states, or alternatively may be left in their original form. Nonetheless, if desired, the precursors may release energy and contact a surface of the substrate in the film forming space, thus forming a deposited film with a three-dimensional network structure. This may happen when the substrate surface temperature is relatively low, or a crystalline deposited film may be formed when the substrate surface temperature is higher.

In the present invention, various parameters may be selected so that film deposition proceeds smoothly to form a film of high quality having the desired physical characteristics. These parameters include the kinds and combination of the starting material, the halogenic oxidising agent, the mixing ratio between them, pressure during mixing, flow rate, pressure within the film forming space, gas flow velocity, and film forming temperature (substrate temperature and atmosphere temperature). These paramaters are mutually related and are not therefore to be determined individually. In the present invention, the ratio of flow rates into the reaction space of gaseous starting material to gaseous halogenic oxidising agent will depend on the various parameters mentioned above, but it is preferably from 1/20 to 100/1, more preferably from 1/5 to 50/1.

The pressure during mixing when introduced into the reaction space may be preferably higher in order to enhance the probability of chemical contact between the above gaseous starting material and the above gaseous halogenic oxidising agent, but it is better to determine the optimum value suitably as desired in view of reactivity. Although the pressure during mixing may be determined as described above, each pressure during introduction may be preferably from $1 \times 10^{-2}$ to $5 \times 10^5$ Pas, more preferably from $1 \times 10^{-1}$ to $2 \times 10^5$ Pa (preferably $1 \times 10^{-7}$ atm to 5 atm, more preferably $1 \times 10^{-6}$ atm to 2 atm).

The pressure within the film forming space, namely the pressure of the space in which a substrate for film formation thereon is placed, may be set suitably as desired so that precursors (E) under excited state generated in the reaction space sometimes precursors (D) formed as secondary products from said precursors (E) may contribute effectively to film formation.

When the film forming space is in open communication with the reaction space, the innter pressure of the film forming space can be controlled with respect to the pressures and flow rates into the reaction space of the starting material and oxidising agent. This can be done, for example, by application of a contrivance such as differential evacuation or use of a large scale evacuating device.

Alternatively, when the conductance at the communicating portion between the reaction space and the film forming space is small the pressure in the film forming space can be controlled by providing an appropriate evacuating device to the film forming space and controlling the evacuation rate of said device.

On the other hand, when the reaction space and the film forming space is integrally made and the reaction position and the film forming position are only different in space, it is possible to effect differential evacuation or provide a large scale evacuating device having sufficient evacuating capacity as described above.

As described above, the pressure in the film forming space may be determined by the introduction pressures of the starting material and the halogenic oxidising agent introduced into the reaction space, but it is preferably from 0.13 to $1.3 \times 10^4$ Pa, more preferably from 1.3 to $4 \times 10^3$ Pa, optimally from 6.67 to $1.3 \times 10^3$ Pa (preferably 0.001 Torr to 100 Torr, more preferably 0.01 Torr to 30 Torr, optimally from 0.05 Torr to 10 Torr).

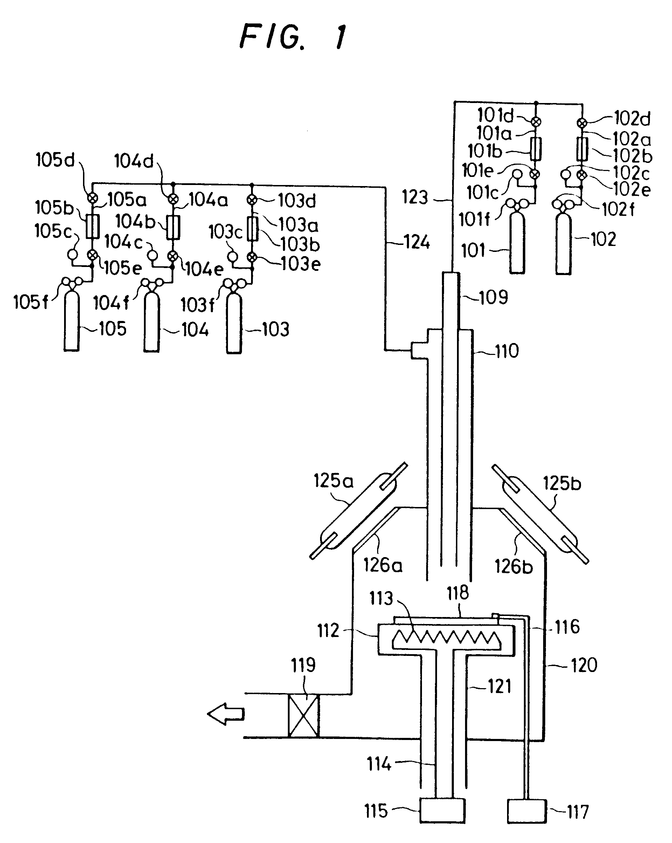

The gas flow velocity is to be chosen in view of the geometric arrangement of a gas introducing port, the substrate and a gas discharging port. The aim is that the starting material and the halogenic oxidising agent may be efficiently mixed during their introduction into the reaction space, the above precursors (E) may be efficiently generated, and film formation may be adequately performed without trouble. A preferred example of the geometric arrangement is shown in Fig 1.

The substrate temperature (Ts) during film formation is to be set as desired, depending on the gas species employed and the kinds and required characteristics of the film to be deposited. Nonetheless, if an amorphous film is to be formed, that temperature is preferably from room temperature to 450°C, more preferably from 50 to 400°C. Particularly, in the case of forming a silicon deposited film with better semiconductor characteristics and photoconductive characteristics, etc, the substrate temperature (Ts) should desirably be made 70 to 350°C. On the other hand, in the case of obtaining a polycrystalline film, it should preferably be 200 to 700°C, more preferably 300 to 600°C.

The atmosphere temperature (Tat) in the film forming space is to be determined in conjunction with the substrate temperature so that the precursors (E) may be efficiently generated, and so that they and precursors (D) are not changed to chemical species unsuitable for film formation.

Fig 1 shows an example of preferred apparatus for forming a deposited structure of the present invention.

The deposited film forming apparatus shown in Fig 1 is broadly divided into a main body (vacuum chamber), an evacuation system and a gas feeding system.

In the main body, a reaction space and film forming space are provided.

101-105 are respectively bombs filled with the gases to be used during film formation, 101a-105a are respectively gas feeding pipes, 101b-105b are respectively mass flow controllers for controlling the flow rates of the gases from the respective bombs, 101c-105c are respectively gas pressure gauges, 101d-105d and 101e-105e are respectively valves, and 101f-105f are respectively pressure gauges indicating the pressures in the corresponding gas bombs.

120 is a vacuum chamber equipped at the upper portion with a means for gas introduction, having a structure for formation of a reaction space downstream of the means, and also having a structure for constituting a film forming space in which a substrate holder 112 is provided so that a substrate 118 may be placed opposite the gas introducing port of said means. The means for gas introduction has a triple concentric tubular structure, having from the innerside a first gas introducing pipe 109 for introducing gases from the gas bombs 101, 102, a second gas introducing pipe 110 for introducing gases from the gas bombs 103-105.

For gas introduction to the reaction space from each gas introducing pipe, each position is designed so as to be arranged farther from the substrate surface as the pipe is nearer to the inner side. In other words, the gas introducing pipes are arranged so that the pipe on the outer side may enclose the pipe existing within the innerside thereof.

The gases from the respective bombs are fed into the respective introducing pipes through the gas feeding pipelines 123-125, respectively.

The respective gas introducing pipes, the respective gas feeding pipelines and the vacuum chamber 120 are evacuated to vacuum through a main vacuum valve 119 by means of an evacuating device not shown.

The substrate 118 is set at a suitable desired distance from the positions of the respective gas introducing pipes by moving vertically the substrate holder 112.

In the case of the present invnetion, the distance between the substrate and the gas introducing port of the gas introducing means may be determined appropriately in view of the kinds and desired characteristics of the deposited film to be formed, the gas flow rates, the inner pressure of the vacuum chamber, etc., but it is preferably several mm to 20 cm, more preferably 5 mm to about l5 cm.

ll3 is a heater for heating the substrate which is provided in order to heat the substrate to an appropriate temperature during film formation, or to preheat the substrate 118 before film formation, or further to anneal the film after film formation.

The substrate heating heater ll3 is supplied with power through a conductive wire ll4 from a power source ll5.

ll6 is a thermocouple for measuring the temperature of the substrate (Ts) and is electrically connected to the temperature display device ll7.

For supplying light energy into the chamber l20, l25a and l25b are light energy generating devices, and light is irradiated through windows l26a and l26b onto the substrate.

The layer to be formed by the photo CVD method is preferably formed by the use of such an apparatus as is adapted for utilization of both the FOCVD method and the optical CVD method as shown in Fig. l. However, it may be formed by the use of a conventional photo CVD apparatus.

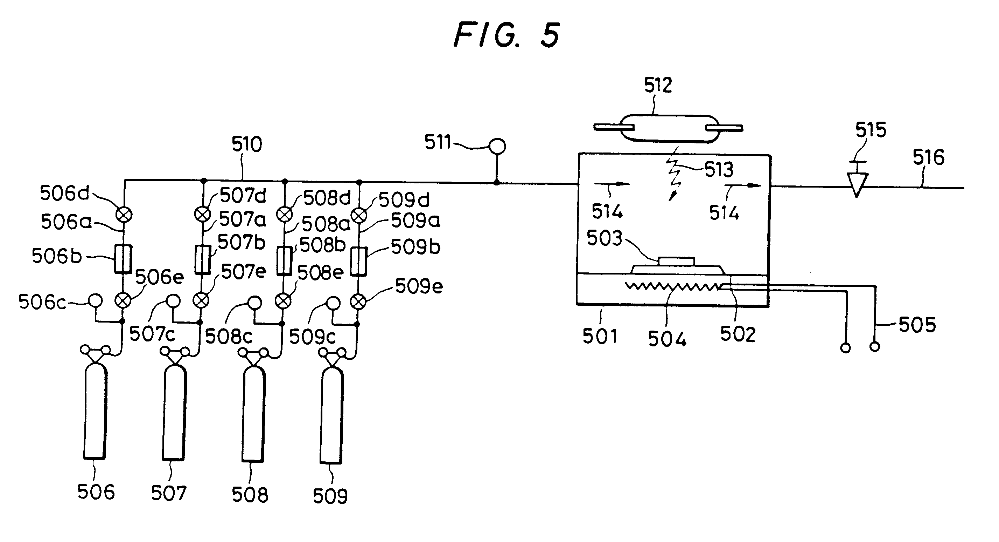

Fig. 5 shows an example of the apparatus for forming a deposited film according to the plasma CVD method, in which 50l is a film forming chamber having a film forming space, and a desired substrate 503 is placed on a substrate supporting stand 502 provided therein.

504 is a heater for heating the substrate and supplied with power through a conductive wire 505 to generate heat.

506 through 509 are gas feeding sources and they are provided corresponding to the kinds of the gases including silicon containing compounds, hydrogen, halogen compounds, inert gas and compounds containing as a component an impurity element for valence electron control. Of these starting material compounds, when those which are liquid under standard state are used, a suitable gasifying device is provided. In the drawing, the numerals of gas feeding sources 506 through 509 affixed with the symbol $\underline{a}$ are branched pipes, those affixed with $\underline{b}$ flowmeters, those affixed with $\underline{c}$ pressure gauges for measuring the pressures on the higher pressure $\underline{side}$ of the respective flowmeters, $\underline{those}$ affixed with $\underline{d}$ or $\underline{e}$ valves for controlling the respective gas flow rates. The gases of the starting material $compound\underline{s}$ $\underline{are}$ introduced through the introducing pipe 510 into the film forming chamber 501.

512 is an optical energy generating device, which acts on the starting material gas flowing in the direction of the arrowhead 514 to excite and decompose the starting material gas to form a deposited film doped with a valence electron controller on the substrate 503 through the chemical reaction of the decomposed compound. 515 is an evacuation valve, and 516 is an evacuation pipe, which is connected to an evacuation device (not shown) for vacuum evacuation internally of the film forming space.

When, for example, a deposited film doped with a valence electron controller is formed by use of such an apparatus, a suitable substrate 503 is placed on the supporting stand 502 and the film forming chamber 501 is internally evacuated to be brought to reduced pressure through an evacuation pipe by use of an evacuation device (not shown).

Next, with heating of the substrate, if desired, starting material gases for film formation such as $SiH_4$, $N_2O$, $H_2$, etc. and the starting material gases for valence electron control such as $B_2H_6$, $PH_3$, etc., are introduced from the gas feeding bombs through the gas introducing pipe 510 into the film forming chamber 501, and optical energy is supplied from the optical energy generating device into the film forming chamber 501 with the pressure in the film forming space being maintained at a predetermined pressure to form an A-Si:H:O:B film on the substrate 503.

In the method of the present invention, as the starting material gas to be introduced into the film forming space for formation of a silicon-containing deposited film according to the optical CVD method, silanes or halogenated silanes having hydrogen, halogen or hydrocarbon group bonded to silicon can be used. Above all, chain or cyclic silane compounds and those wherein hydrogen atoms are partially or wholly substituted with halogen atoms are preferred.

Specifically, for example, there may be included straight chain silane compounds represented by $Si_pH_{2p+2}$ (p is an integer of 1 or more, preferably 1 to 15, more preferably 1 to 10) such as $SiH_4$, $Si_2H_6$, $Si_3H_8$, $Si_4H_{10}$, $Si_5H_{12}$, $Si_6H_{14}$, etc.; branched chain silane compounds represented by $Si_pH_{2p+2}$ (p has the same meaning as defined above) such as $SiH_3SiH(SiH_3)SiH_3$, $SiH_3SiH(SiH_3)Si_2H_5$, $Si_2H_5SiH(SiH_3)Si_2H_5$, etc., these straight chain or branched silane compounds of which hydrogen atoms are partially or wholly substituted with halogen atoms; cyclic silane compounds represented by $Si_qH_{2q}$ (q is an integer of 3 or more, preferably 3 to 6) such as $Si_3H_6$, $Si_4H_8$, $Si_5H_{10}$, $Si_6H_{12}$, etc.; said cyclic silane compounds of which hydrogen atoms are partially or wholly substituted with other cyclic silanyl groups and/or chain silanyl

EP 0 231 660 B1

groups; etc. Examples of the above silane compounds of which hydrogen atoms are partially or wholly substituted with halogen atoms may include halo-substituted chain or cyclic silane compounds represented by $SiH_rH_sX_t$ (X is halogen atom, r is an integer of 1 or more, preferably 1 to 10, more pareferably 3 to 7, s + t = 2r + 2 or 2r) such as $SiH_3F$, $SiH_3C\ell$, $SiH_3Br$, $SiH_3I$, etc. These compounds may be used either singly or as a combination of two or more compounds. Further, these starting material gases may be also used as diluted with an inert gas such as He, Ar, etc.

The valence electron controller to be used in the present invention may include, in the case of silicon type semiconductor films and germanium type semiconductor films, p-type valence electron controller, namely compounds containing elements of the group III of the periodic table functioning as the so-called p-type impurity such as B, $A\ell$, Ga, In, $T\ell$, etc., and n-type valence electron controller, namely compounds containing elements of the group V of the periodic table functioning as the so-called n-type impurity such as N, P, As, Sb, Bi, etc.

Specifically, there may be included $NH_3$, $HN_3$, $N_2H_5N_3$, $N_2H_4$, $NH_4N_3$, $PH_3$, $P_2H_4$, $AsH_3$, $SbH_3$, $BiH_3$, $B_2H_6$, $B_4H_{10}$, $B_5H_9$, $B_5H_{11}$, $B_6H_{10}$, $B_6H_{12}$, $A\ell(CH_3)_3$, $A\ell(C_2H_5)_3$, $Ga(CH_3)_3$, $In(CH_3)_3$, etc. as effective ones.

The high energy light to be used in the method of the present invention may be one generated from, for example, low pressure mercury lamp, xenon lamp, carbonic acid gas laser, argon ion laser, excimer laser, etc. as the generation source. The light energy to be used in the present invention is not limited to UV-ray energy, but its wavelength is not limited, provided that it can excite, decompose or polymerize the starting material gas to deposit decomposed products. Also, the case when light energy is absorbed into the starting material gas or the substrate to be converted to heat energy and excitation or decomposition or polymerization of the starting material gas is brought about by the heat energy to form a deposited film is not excluded.

In the present invention, the method for forming a deposited film doped with a valence electron controller is essentially different from that for formation of the deposited film having semiconductor characteristics not doped with a valence controller, but both of the deposited film forming means can be arranged in a single apparatus for forming deposited film. In this case, when either one of the deposited film forming means is employed, the other deposited film forming means is stopped.

Also, it is possible to arrange both of the deposited film forming means adjacent to each other separated by a gate valve, etc. and carry out formation of deposited films continuously.

The substrate to be used in the present invention may be either electroconductive or electrically insulating, provided that it is selected as desired depending on the use of the deposited film formed. As an electroconductive substrate, there may be mentioned metals such as NiCr, stainless steel, $A\ell$, Cr, Mo, Au, Ir, Nb, Ta, V, Ti, Pt, Pd, etc., or alloys thereof.

As an insulating substrate, there may be conventionally be used films or sheets of synthetic resins, including polyesters, polyethylene, polycarbonate, cellulose acetate, polypropylene, polyvinyl chloride, polyvinylidene chloride, polystyrene, polyamides, etc., glass, ceramics and so on. At least one side surface of these substrates is preferably subjected to treatment for imparting electroconductivity, and it is desirable to provide other layers on the side at which said electroconductive treatment has been applied.

For example, electroconductive treatment of a glass substrate can be effected by providing a thin film of NiCr, $A\ell$, Cr, Mo, Au, Ir, Nb, Ta, V, Ti, Pt, Pd, $In_2O_3$, $SnO_2$, ITO ($In_2O_3$ + $SnO_2$) thereon. Alternatively, a synthetic resin film such as polyester film can be subjected to the electroconductive treatment on its surface by vacuum vapor deposition, electron-beam deposition or sputtering of a metal such as NiCr, $A\ell$, Ag, Pb, Zn, Ni, Au, Cr, Mo, Ir, Nb, Ta, V, Ti, Pt, etc., or by laminating treatment with such metals, thereby imparting electroconductivity to the surface. The substrate may be shaped in any form such as cylinders, belts, plates or others, and its form may be determined as desired.

The substrate should be preferably selected from among those set forth above in view of adhesion and reactivity between the substrate and the film. Further, if the difference in thermal expansion between both is great, a large amount of strains may be created within the film to give sometimes no film of good quality, and therefore it is preferable to use a substrate so that the difference in thermal expansion between both is small.

Also, the surface state of the substrate is directly related to the structure of the film (orientation) or generation of or a stylet structures, and therefore it is desirable to treat the surface of the substrate to give a film structure and a film texture so that desired characteristics may be obtained.

Example 1

By use of the apparatus for forming a deposited film shown in Fig. 1, a thin film transistor shown in Fig. 2 (hereinafter referred to as "TFT") was prepared.

8

The above TFT is constituted of a glass substrate 234 (7059, produced by Corning Co.), an amorphous silicon layer (first layer, thickness 700 nm, 7000 Å) 233, an amorphous silicon layer doped with phosphorus to a high concentration (second layer, thickness 50 nm, 500 Å) 232, a silicon oxide layer (third layer, thickness 100 nm, 1000 Å), 231 Aℓ electrodes 228, 229, 230.

In this example, in depositing the amorphous silicon layer 232 doped with phosphorus to a high concentration, $SiH_4$ gas filled in the bomb 101 was introduced at a flow rate of 20 sccm through the gas introducing pipe 109, $PH_3$/He gas ($PH_3$ concentration 1000 ppm) filled in the bomb 103 at a flow rate of 3 sccm through the gas introducing pipe 110 and He gas filled in the bomb 104 at a flow rate of 30 sccm through the gas introducing pipe 110, and irradiation of light was effected by use of low pressure mercury lamps 125a, 125b at 15 mW/cm$^2$.

The amorphous silicon layer 233 and the silicon oxide layer 231 were deposited by mixing and reacting a gaseous starting material for formation of a deposited film and a gaseous halogenic oxidizing agent having the property of oxidative action for said starting material in the vacuum chamber 120 (by FOCVD).

For the amorphous silicon layer 233, $SiH_4$ gas filled in the bomb 101 was introduced at a flow rate of 20 sccm through the gas introducing pipe 109, $F_2$ gas filled in the bomb 104 at a flow rate of 10 sccm, He gas filled in the bomb 107 at 100 sccm through the gas introducing pike 110 into the vacuum chamber 120.

During this operation, the Pressure in the vacuum chamber 120 was made 93.3 Pa (0.7 Torr) by controlling the opening of the vacuum valve 119. The distance between the gas introducing pipe 111 and the substrate was set at 3 cm. In the mixing region of $SiH_4$ gas and $F_2$ gas, blueish white luminescence was strongly observed.

For the silicon oxide layer 231, $SiH_4$ gas filled in the bomb 101 was introduced at a flow rate of 15 sccm through the gas intorducing pipe 109, $N_2O$ gas filled in the bomb 106 at a flow rate of 5 sccm and He gas filled in the bomb 107 at a flow rate of 30 sccm through the gas introduing pipe 111 into the vacuum chamber 120.

During this operation, the pressure in the vacuum chamber 120 was made 0.3 Torr by controlling the opening of the vacuum valve 119.

During formation of all the layers, the substrate temperature was set at 250°C.

The TFT prepared by this Example exhibited an on-off ratio improved by about 15 % as compared with the prior art product.

Example 2

By use of the apparatus for forming a deposited film shown in Fig. 1, a solar battery having the layer constitution shown in Fig. 3 was produced.

The above solar battery is constituted of a Corning 7059 glass substrate 300 having a transparent electrode vapor deposited thereon, a p-type amorphous silicon layer (first layer, thickness 50 nm, 500 Å) 301, an i-type amorphous silicon layer (second layer, thickness 1 μm) 302, an n-type amorphous silicon layer (third layer, thickness 50 nm, 500 Å) 303 and an Aℓ electrode 304.

The first layer 301 was deposited by the same optical CVD as practiced in Example 1, and subsequently the second layer and the third layer were deposited by mixing and reacting the same gaseous starting material for formation of a deposited film and the gaseous halogenic oxidizing agent having the property of oxidative action for said starting material as used in Example 1 in the vacuum chamber 120 (by FOCVD).

The film forming conditions according to this Example are shown in Table 1.

The solar battery thus obtained exhibited a conversion efficiency improved by 20 % as compared with the prior art product.

Example 3

By use of the apparatus for forming a deposited film shown in Fig. 1, an image forming member for electrophotography having the layer constitution shown in Fig. 4 was prepared.

The above image forming member for electrophotography shown in Fig. 4 is constituted of a substrate made of aluminum 400, a charge injection preventing layer (first layer, amorphous silicon layer doped with B, 0.5 μm) 401, a photosensitive member (second layer, amorphous silicon layer 18 μm) 402, a surface protective layer (third layer, amorphous silicon carbide layer 0.1 μm) 403.

According to the method shown in Example 1, an image forming member for electrophotography was produced under the film forming conditions shown in Table 2.

The image forming member for electrophotography obtained by this Example exhibited charging characteristics improved by 25 % or more, and also reduced in image defect number by about 10 % as compared with the prior art product the respective layers of which are continuously formed by the PCVD method.

Table 1

| (substrate temperature 250 ° C) | | | | |
|---|---|---|---|---|
| Layer constitution | Starting material | Flow rate (sccm) | Deposition method | Pressure (Torr) Pa |
| First layer (p-type) | $SiH_4$<br>$B_2H_6$/He (1000ppm)<br>He | 20<br>2.5<br>20 | Photo CVD | (0.3) 40 |
| Second layer (i-type) | $SiH_4$<br>$F_2$<br>He | 30<br>30<br>200 | FOCVD | (0.8) 106.7 |
| Third layer (n-type) | $SiH_4$<br>$PH_3$/He (1000ppm)<br>$F_2$<br>He | 20<br>2<br>15<br>100 | FOCVD | (0.5) 66.7 |

Table 2

| (substrate temperature 280 ° C) | | | | |
|---|---|---|---|---|
| Layer constitution | Starting material | Flow rate (sccm) | Deposition method | Pressure (Torr) Pa |
| First layer (p-type) | $SiH_4$<br>$B_2H_6$/He (1000ppm)<br>$N_2O$<br>He | 25<br>3.5<br>9<br>25 | Photo CVD | (0.3) 40 |
| Second layer (i-type) | $SiH_4$<br>$F_2$<br>He | 100<br>80<br>250 | FOCVD | (0.9) 120 |
| Third layer (A-SiC:H) | $SiH_4$<br>$CH_4$<br>He | 20<br>300<br>10 | PCVD | (0.4) 53.3 |

**Claims**

1. A method for producing a multi-layer structure comprising two or more semiconductor layers at least one of which is a thin layer controlled in valence electron, formed on a substrate, which comprises:
   (a) forming at least one of said semiconductor thin layers controlled in valence electron according to photo CVD by bringing together a gaseous starting material and a valence electron controller;
   (b) forming at least one of the other constituent layers, optionally controlled in valence electron, according to a method comprising:
       (i) introducing a gaseous starting material for formation of a deposited film and a gaseous halogenic oxidising agent having the property of oxidising said starting material into a reaction space to effect chemical contact therebetween to thereby form a plural number of precursors containing a precursor under excited state; and
       (ii) transferring at least one precursor of those precursors into a film forming space communicated with the reaction space as a feeding source for the constituent element of the deposited film.

2. A method according to claim 1, wherein said gaseous starting material is a chain silane compound.

10

3. A method according to claim 2, wherein said chain silane compound is a straight chain silane compound.

4. A method according to claim 3, wherein said straight chain silane compound is represented by the formula $Si_nH_{2n+2}$ ( $\underline{n}$ is an integer of 1 to 8).

5. A method according to claim 2, wherein said chain silane compound is a branched chain silane compound.

6. A method according to claim 1, wherein said gaseous starting material is a silane compound having a cyclic structure of silicon.

7. A method according to claim 1, wherein said gaseous starting material is a chain germane compound.

8. A method according to claim 7, wherein said chain germane compound is represented by the formula $Ge_mH_{2m+2}$ ( $\underline{m}$ is an integer of 1 to 5).

9. A method according to claim 1, wherein said gaseous starting material is a hydrogenated tin compound.

10. A method according to claim 1, wherein said gaseous starting material is a group IVA element-containing compound.

11. A method according to claim 1, wherein said gaseous halogenic oxidising agent contains a halogen gas.

12. A method according to claim 1, wherein said gaseous halogenic oxidising agent contains fluorine gas.

13. A method according to claim 1, wherein said gaseous halogenic oxidixing agent contains chlorine gas.

14. A method according to claim 1, wherein said gaseous halogenic oxidising agent is a gas containing fluorine atoms as a constituent.

15. A method according to claim 1, wherein said gaseous halogenic oxidising agent contains a halogen under nascent state.

16. A method according to claim 1, wherein said substrate is arranged at a position opposed to the direction in which said gaseous starting material and said gaseous halogenic oxidising agent are introduced into said reaction space.

**Patentansprüche**

1. Verfahren zur Herstellung einer Mehrschicht-Struktur, die zwei oder mehr auf einem Schichtträger gebildete Halbleiterschichten umfaßt, von denen mindestens eine eine in ihren Valenzelektronen eingestellte Dünnschicht ist, umfassend:
    (a) Ausbilden mindestens einer der in ihren Valenzelektronen eingestellten Halbleiter-Dünnschichten durch das Zusammenbringen eines gasförmigen Ausgangsmaterials und eines Valenzelektronen-Einstellmittels nach dem Foto-CVD-Verfahren;
    (b) Ausbilden mindestens einer der anderen, einen Bestandteil bildenden, gegebenenfalls in den Valenzelektronen eingestellten Schichten nach einem Verfahren, welches
        (i) das Einführen eines gasförmigen Ausgangsmaterials zur Bildung eines abgeschiedenen Films und eines gasförmigen, halogenhaltigen Oxidationsmittels, welches die Eigenschaft aufweist, das Ausgangsmasterial zu oxidieren, in einen Reaktionsraum, um chemischen Kontakt zwischen diesen zu bewirken, um dadurch eine Vielzahl von Vorläufern, unter denen ein Vorläufer in angeregtem Zustand enthalten ist, zu bilden, und
        (ii) das Überführen mindestens eines Vorläufers dieser Vorläufer in einen mit dem Reaktionsraum in Verbindung stehenden Filmbildungsraum als Zufuhrquelle für das Bestandteilselement des abgeschiedenen Films

umfaßt.

2. Verfahren nach Anspruch 1, dadurch gekennzeichnet, daß als gasförmiges Ausgangsmaterial eine Ketten-Silanverbindung eingesetzt wird.

3. Verfahren nach Anspruch 2, dadurch gekennzeichnet, daß als Ketten-Silanverbindung eine Geradketten-Silanverbindung eingesetzt wird.

4. Verfahren nach Anspruch 3, dadurch gekennzeichnet, daß die Geradketten-Silanverbindung durch die Formel $Si_nH_{2n+2}$ repräsentiert wird, worin n eine ganze Zahl von 1 bis 8 ist.

5. Verfahren nach Anspruch 2, dadurch gekennzeichnet, daß als Ketten-Silanverbindung eine Verzweigtketten-Silanverbindung eingesetzt wird.

6. Verfahren nach Anspruch 1, dadurch gekennzeichnet, daß als gasförmiges Ausgangsmaterial eine Silanverbindung mit einer cyclischen Siliziumstruktur eingesetzt wird.

7. Verfahren nach Anspruch 1, dadurch gekennzeichnet, daß als gasförmiges Ausgangsmaterial eine Ketten-Germaniumwasserstoffverbindung eingesetzt wird.

8. Verfahren nach Anspruch 7, dadurch gekennzeichnet, daß die Ketten-Germaniumwasserstoffverbindung durch die Formel $Ge_mH_{2m+2}$ repräsentiert wird, worin m eine ganze Zahl von 1 bis 5 ist.

9. Verfahren nach Anspruch 1, dadurch gekennzeichnet, daß als gasförmiges Ausgangsmaterial eine hydrierte Zinnverbindung eingesetzt wird.

10. Verfahren nach Anspruch 1, dadurch gekennzeichnet, daß als qasförmiges Ausgangsmaterial eine Gruppe IVA-Element enthaltende Verbindung eingesetzt wird.

11. Verfahren nach Anspruch 1, dadurch gekennzeichnet, daß das gasförmige, halogenhaltige Oxidationsmittel ein Halogengas enthält.

12. Verfahren nach Anspruch 1, dadurch gekennzeichnet, daß das gasförmige, halogenhaltige Oxidationsmittel Fluorgas enthält.

13. Verfahren nach Anspruch 1, dadurch gekennzeichnet, daß das gasförmige, halogenhaltige Oxidationsmittel Chlorgas enthält.

14. Verfahren nach Anspruch 1, dadurch gekennzeichnet, daß das gasförmige, halogenhaltige Oxidationsmittel ein Gas ist, welches Fluoratome als Bestandteil enthält.

15. Verfahren nach Anspruch 1, dadurch gekennzeichnet, daß das gasförmige, halogenhaltige Oxidationsmittel ein Halogen in naszierendem Stadium enthält.

16. Verfahren nach Anspruch 1, dadurch gekennzeichnet, daß der Schichtträger in einer Position angeordnet ist, die der Richtung, in der das gasförmige Ausgangsmaterial und das gasförmige, halogenhaltige Oxidationsmittel in den Reaktionsraum eingeführt werden, entgegengesetzt ist.

**Revendications**

1. Procédé de fabrication d'une structure multicouche comprenant deux ou plus de deux couches à semiconducteurs dont l'une au moins est une couche mince contenant un régulateur d'électrons de valence, formées sur un substrat,
    qui consiste :
    (a) à former au moins l'une desdites minces couches à semiconducteurs contenant un régulateur d'électrons de valence conformément au procédé optique de déposition chimique sous vide par réunion d'une matière gazeuse de départ et d'un régulateur d'électrons de valence ;
    (b) à former au moins l'une des autres couches constitutives, contenant facultativement un régulateur d'électrons de valence, conformément à un mode opératoire consistant :

(i) à introduire une matière gazeuse de départ pour la formation d'une pellicule déposée et un agent oxydant halogéné gazeux ayant la propriété d'oxyder ladite matière de départ dans un espace de réaction pour établir un contact chimique entre les deux de manière à former ainsi une pluralité de précurseurs contenant un précurseur à l'état excité ; et

(ii) à transférer au moins l'un de ces précurseurs dans un espace de formation d'un film en communication avec l'espace de réaction comme source d'alimentation en l'élément constitutif du film déposé.

2.  Procédé suivant la revendication 1, dans lequel la matière gazeuse de départ est un silane en chaîne.

3.  Procédé suivant la revendication 2, dans lequel le silane en chaîne est un silane à chaîne droite.

4.  Procédé suivant la revendication 3, dans lequel le silane à chaîne droite est représenté par la formule $Si_nH_{2n+2}$ (dans laquelle n est un nombre entier de 1 à 8).

5.  Procédé suivant la revendication 2, dans lequel le silane en chaîne est un silane à chaîne ramifiée.

6.  Procédé suivant la revendication 1, dans lequel la matière gazeuse de départ est un silane ayant une structure cyclique du silicium.

7.  Procédé suivant la revendication 1, dans lequel la matière gazeuse de départ est un germane en chaîne.

8.  Procédé suivant la revendication 7, dans lequel le germane en chaîne est représenté par la formule $Ge_mH_{2m+2}$ (dans laquelle $m$ est un nombre entier de 1 à 5).

9.  Procédé suivant la revendication 1, dans lequel la matière gazeuse de départ est un composé d'étain hydrogéné.

10. Procédé suivant la revendication 1, dans lequel la matière gazeuse de départ est un composé contenant un élément du Groupe IVA.

11. Procédé suivant la revendication 1, dans lequel l'agent oxydant halogéné gazeux contient un halogène gazeux.

12. Procédé suivant la revendication 1, dans lequel l'agent oxydant halogéné gazeux contient du fluor gazeux.

13. Procédé suivant la revendication 1, dans lequel l'agent oxydant halogéné gazeux contient du chlore gazeux.

14. Procédé suivant la revendication 1, dans lequel l'agent oxydant halogéné gazeux est un gaz contenant des atomes de fluor comme constituant.

15. Procédé suivant la revendication 1, dans lequel l'agent oxydant halogéné gazeux contient un halogène à l'état naissant.

16. Procédé suivant la revendication 1, dans lequel le substrat occupe une position opposée à la direction dans laquelle la matière gazeuse de départ et l'agent oxydant halogéné gazeux sont introduits dans l'espace de réaction.

EP 0 231 660 B1

# FIG. 1

14

*FIG. 2*

228 229 230
232
231 233
234

*FIG. 3*

304
303
302
301
300

*FIG. 4*

403
402
401
400

**FIG. 5**